# EUROPEAN PATENT APPLICATION

(11) **EP 4 572 538 A1**
(43) Date of publication of application: **18.06.2025**
(21) Application number: 23852230.4
(22) Date of filing: 07.06.2023
(51) Int. Cl.: H05K 1/03, B32B 7/025, C03C 27/12, C09J 7/00, C09J 9/00, H01B 5/14, H01B 13/00, H05K 3/38

(54) **ADHESIVE BASE MATERIAL WITH WIRING LINE, MULTILAYER DEVICE, GLASS LAMINATE, AND METHOD FOR PRODUCING ADHESIVE BASE MATERIAL WITH WIRING LINE**

(30) Priority: 12.08.2022 JP 2022128817
(71) Applicant: AGC INC., Chiyoda-ku, Tokyo 1008405 (JP)
(72) Inventor: FUJITA, Kenji, Tokyo 100-8405 (JP)
(74) Representative: Müller-Boré & Partner Patentanwälte PartG mbB
(86) International application number: PCT/JP2023/021103
(87) International publication number: WO 2024/034246

(57) **Abstract**

To provide a wiring-attached adhesive substrate that can suppress the occurrence of crack and buckling in the wiring pattern formed on the adhesive layer. The wiring-attached adhesive substrate (1) according to one aspect of the present disclosure comprises a substrate (10), an adhesive layer (11) formed on the substrate (10), and a wiring pattern (12) formed on the adhesive layer (11). The adhesive layer (11) has an adhesive strength of 0.01 N/25 mm or more to a PET film, layer thickness variation when the adhesive layer is immersed in isopropyl alcohol for 1 minute is 20% or less, and layer thickness variation when the adhesive layer is immersed in toluene for 1 minute is 18% or less.

## Description

### Technical Field

The present disclosure relates to wiring-attached adhesive substrate, stacked device, glass stacked body, and a method for manufacturing wiring attached adhesive substrate.

### Background Art

Tiling technology is one of the technologies for forming large size electronic devices. Tiling technology is a technology in which a plurality of electronic devices is arrayed on a substrate and adjacent electronic devices are electrically connected to form a large size electronic device. For example, plural display devices are arrayed on a substrate and these display devices can be electrically connected to form a large screen display device.

Patent Document 1 discloses a transfer film for forming a transparent conductive layer and a technique for manufacturing a transparent conductive laminate using the transfer film.

### Citation List

### Patent Literature

**Patent Literature 1** : Japanese Patent No. 5430792

### Summary of Invention

### Technical Problem

When configuring an electronic device using tiling technology, it is necessary to array a plurality of electronic devices on a substrate and electrically connect the arrayed electronic devices using wiring. To collectively perform the adhesion between the arrayed electronic devices and electrical connection by wiring, it is useful to use component in which wiring is installed via an adhesive layer on the above-described substrate. As a result, it is necessary to form wiring for electrically connecting a plurality of electronic devices on the adhesive layer that adheres the plurality of electronic devices. In the technique disclosed in Patent Document 1, a wiring is formed on a substrate for transfer, and a wiring is formed on the adhesive layer by transferring the wiring onto the adhesive layer of the tiling substrate.

However, when such a transfer technique is used, there is a problem that the number of manufacturing step increases, and there is a problem that the auxiliary materials used for manufacturing increase accordingly. Furthermore, when the transfer technique is used, the wiring pattern may collapse when the wiring pattern is transferred onto the adhesive layer.

As a result, the inventor of the present application has considered a technique for directly forming a wiring pattern on an adhesive layer. However, when the wiring pattern is directly formed on the adhesive layer, a new problem was found that crack and buckling occur in the formed wiring.

In view of the above-mentioned problems, an object of the present disclosure is to provide a wiring-attached adhesive substrate, a stacked device, and glass stacked body that can suppress the occurrence of crack and buckling in the wiring pattern formed on the adhesive layer, as well as to provide a method for manufacturing the wiring attached adhesive substrate.

### Solution to Problem

The wiring-attached adhesive substrate according to one aspect of the present disclosure includes a substrate, an adhesive layer formed on the substrate, and a wiring pattern formed on the adhesive layer. The adhesive layer has an adhesive strength of 0.01 N/25 mm or more to a PET film, a layer thickness variation when the adhesive layer is immersed in isopropyl alcohol for 1 minute is 20% or less, and a layer thickness variation when the adhesive layer is immersed in toluene for 1 minute is 18% or less.

In the wiring-attached adhesive substrate described above, the wiring pattern may be composed of a material containing at least one selected from the group consisting of silver, copper, carbon, and gold.

In the wiring-attached adhesive substrate described above, a light transmittance of the entire surface of the wiring-attached adhesive substrate may be 50% or more.

A stacked device according to one aspect of the present disclosure includes a wiring-attached adhesive substrate described above and an electronic device disposed on the wiring-attached adhesive substrate. The electronic device is electrically connected to the wiring pattern formed on the adhesive layer.

The stacked device described above may further includes an over coat layer covering the electronic device and the wiring pattern.

A glass stacked body according to one aspect of the present disclosure is a glass stacked body in which the stacked device described above is encapsulated in a glass plate or laminated to the surface of a glass plate.

A method for manufacturing a wiring-attached adhesive substrate according to one aspect of the present disclosure includes a step of forming an adhesive layer on a substrate and a step of forming a wiring pattern on the adhesive layer using a conductive ink material. The adhesive layer uses a material having an adhesive strength of 0.01 N/25 mm or more to a PET film, a layer thickness variation of 20% or less when the adhesive layer is immersed in isopropyl alcohol for 1 minute, and a layer thickness variation of 18% or less when the adhesive layer is immersed in toluene for 1 minute.

In the method for manufacturing a wiring-attached adhesive substrate described above, the step of forming a wiring pattern may be a step of printing the conductive ink material on the adhesive layer using inkjet technique to form the wiring pattern.

In the method for manufacturing a wiring-attached adhesive substrate described above, the step of forming a wiring pattern may be a step of printing the conductive ink material on the adhesive layer using screen printing technique to form the wiring pattern.

### Advantageous Effects of Invention

The present disclosure can provide a wiring-attached adhesive substrate, a stacked device, and glass stacked body that can suppress the occurrence of crack and buckling in the wiring pattern formed on the adhesive layer, as well as to provide a method for manufacturing the wiring-attached adhesive substrate.

### Brief Description of Drawings

Fig. 1 is a cross-sectional view showing a configuration example of a wiring-attached adhesive substrate according to the embodiment;
Fig. 2 is a plan view showing configuration example of a stacked device according to the embodiment;
Fig. 3 is a cross-sectional view showing configuration example of a stacked device according to the embodiment;
Fig. 4 is a cross-sectional view showing configuration example of a stacked device according to the embodiment;
Fig. 5 is a cross-sectional view showing configuration example of a glass stacked body according to the embodiment;
Fig. 6 is a cross-sectional view for explaining a method for measuring the layer thickness variation;
Fig. 7 is microscopically observed photographs of the samples according to Example 1 to Example 6; and
Fig. 8 is microscopically observed photographs of the samples according to Example 7 to Example 13.

### Description of Embodiments

Hereinafter, embodiments will be described with reference to the drawings.

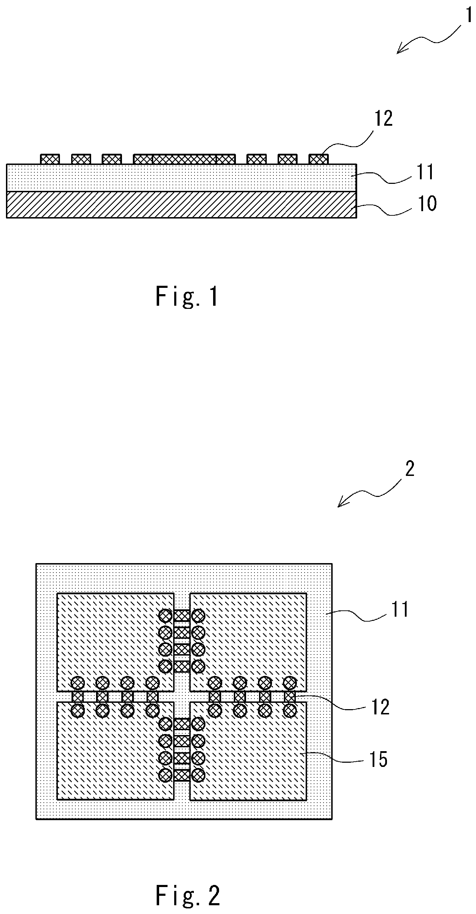

Fig. 1 is a cross-sectional view showing a configuration example of a wiring-attached adhesive substrate according to the embodiment. As shown in Fig. 1, the wiring-attached adhesive substrate 1 according to the present embodiment includes a substrate 10, adhesive layer 11, and wiring pattern 12. In addition, in the present specification, the wiring pattern 12 may be simply described as wiring 12.

The substrate 10 is a component for supporting a plurality of electronic devices 15 (see Fig. 2) adhered using the adhesive layer 11. The substrate 10 may be configured with a rigid material or a flexible material. In addition, the substrate 10 may be configured using a transparent material, or may be configured using a material having a small retardation value to prevent rainbow unevenness during observation. For example, TAC (Triacetylcellulose), acrylic resin, COP (Cyclo Olefin Polymer), CPI (Colorless and Transparent Polyimide), and the like can be used as the substrate 10.

The thickness of the substrate 10 is, for example, about 12 µm to 250 µm. The thickness of the substrate 10 may be changed according to the processability of a post-process such as laminated glass encapsulation. Furthermore, a functional layer may be provided separately on the substrate 10. For example, the functional layer is an easy-to-adhere layer, an oxygen barrier layer, a water vapor barrier layer, an invisible layer, an antistatic layer and the like.

The adhesive layer 11 is formed on the substrate 10, and is a component for adhering a plurality of electronic devices 15 (see Fig. 2) to the substrate 10. For example, a transparent adhesive material, that is, an Optical Clear Adhesive (OCA), can be used for the adhesive layer 11. The thickness of the adhesive layer 11 is, for example, 5 µm to 200 µm. Details of the adhesive layer 11 will be described later.

The wiring pattern 12 is formed on the adhesive layer 11. For example, the wiring pattern 12 can be formed by drawing directly on the adhesive layer 11. Specifically, the wiring pattern 12 can be formed by printing a conductive ink material on the adhesive layer 11 using inkjet technique. Furthermore, the wiring pattern 12 may be formed by printing the conductive ink material on the adhesive layer 11 using screen printing technique.

For example, the wiring pattern 12 can be composed of a material containing at least one selected from the group consisting of silver, copper, carbon, and gold. That is, the wiring pattern 12 may be formed using the conductive ink material (wiring ink material) containing at least one selected from the group consisting of silver, copper, carbon, and gold. The wiring width of the wiring pattern 12 is, for example, 1.5 µm to 10 mm.

The wiring-attached adhesive substrate 1 according to the present embodiment may be transparent. For example, the light transmittance of the entire surface of the wiring-attached adhesive substrate according to the present embodiment may be 50% or more, preferably 60% or more, and more preferably 80% or more. Here, the light transmittance of the entire surface of the wiring-attached adhesive substrate is the average value of the total light transmittance of entire area of the substrate regardless of the installation location of the wiring.

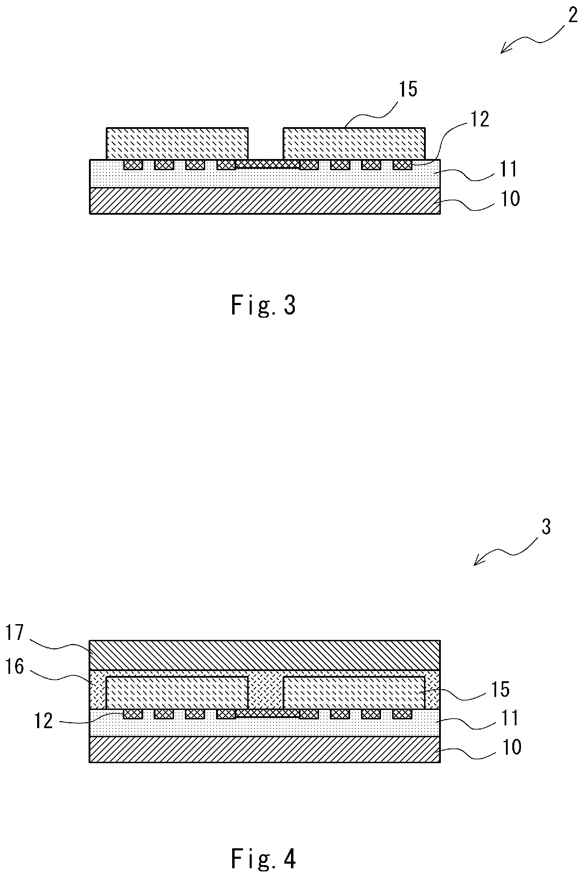

Next, a stacked device in which a plurality of electronic devices is mounted on a wiring-attached adhesive substrate will be described. Fig. 2 is a plan view illustrating a configuration example of the stacked device 2 according to the embodiment. Fig. 3 is a cross-sectional view illustrating a configuration example of the stacked device 2 according to the embodiment.

As shown in Figs. 2 and 3, the plurality of electronic devices 15 is disposed on the wiring-attached adhesive substrate 1. Specifically, the plurality of electronic devices 15 is adhered to the adhesive layer 11 of the wiring-attached adhesive substrate 1. As a result, the plurality of electronic devices 15 is fixed to the substrate 10. At this time the electronic device 15 is electrically connected to the wiring pattern 12 formed on the adhesive layer 11. For example, the electronic device 15 is a display device, an optical device, a sensor device, a heating device, and the like, and a connecting component such as Flexible Printed Circuits (FPC) may also be connected. In addition, in the present embodiment, the electronic device 15 may be an electronic device besides these.

Furthermore, the stacked device according to the present embodiment may include an over coat layer 16 and a substrate 17 as shown in the stacked device 3 shown in Fig. 4. The over coat layer 16 is a component that covers and protects a plurality of electronic devices 15 and wiring pattern 12. Specifically, by providing the over coat layer 16, chemical degradation such as oxidation and corrosion of the electronic device 15 and the wiring pattern 12 can be suppressed. Furthermore, when the over coat layer 16 is provided, local pressure is applied to the edge portion or the like where the wiring-attached adhesive substrate 1 and the electronic device 15 come into contact, and mechanical degradation such as wire breakage can suppressed. For over coat layer 16, for example, a curing resin, Optical Clear Resin (OCR), and the like can be used.

The substrate 17 is a component protecting the plurality of electronic devices 15, and can be effectively protected by sandwiching the plurality of electronic devices 15 between the lower side substrate 10 and the upper side substrate 17. The same material of as the substrate 10 described above can be used for the substrate 17. The over coat layer 16 includes adhesiveness, and the substrate 17 can be adhered to the over coat layer 16 by arranging the substrate 17 on the over coat layer 16. Furthermore, the substrate 17 may be separately provided with a functional layer in the same manner as the substrate 10. For example, the functional layer is an easy-to-adhere layer, an oxygen barrier layer, a water vapor barrier layer, an invisible layer, an antistatic layer and the like.

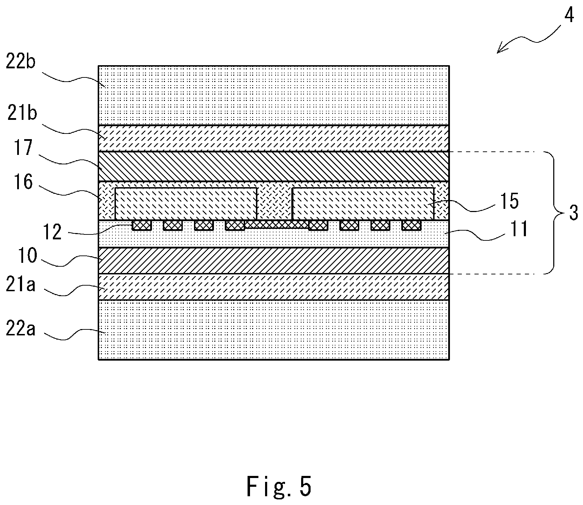

Furthermore, in the present embodiment, the stacked device 3 shown in Fig. 4 may be configured to be encapsulated in a glass plate or laminated to a glass plate surface to form a glass stacked body. Fig. 5 is a cross-sectional view showing configuration example of a glass stacked body according to the embodiment. Fig. 5 shows an example in which the laminating device 3 shown in Fig. 4 is encapsulated in a glass plate to form glass stacked body 4.

The glass stacked body 4 shown in Fig. 5 includes intermediate bonding layers 21a, 21b on the upper surface and the lower surface of the stacked device 3, respectively. For the intermediate bonding layers 21a, 21b, for example, polyvinyl butyral (PVB), ethylene-vinyl acetate copolymer (EVA), and the like can be used.

Glass plates 22a and 22b are provided on the outer surfaces of each intermediate bonding layers 21a and 21b. For the glass plates 22a and 22b, for example, inorganic glass can be used. Examples of the inorganic glass include soda-lime glass, aluminosilicate glass, borosilicate glass, alkali-free glass, and quartz glass. In addition, an organic glass (resin) may be used for the glass plates 22a and 22b. Examples of the organic glass include polycarbonate, acrylic resin such as polymethyl methacrylate, polyvinyl chloride, and polystyrene.

For example, when a display device is used as the electronic device 15, the display device can form a glass stacked body 4 encapsulated in the glass plates 22a and 22b. For example, by using such a glass stacked body 4 as a windshield of a vehicle, a windshield with a built-in display device can be configured. In addition, by using such a glass stacked body 4 for the window glass of a building, a window glass with a built-in display device can be configured.

As described above, in the present embodiment, a wiring pattern 12 is formed by drawing directly on the adhesive layer 11. For this reason, the characteristics of the adhesive layer 11 are important to suppress the occurrence of crack and buckling of the wiring pattern 12 formed on the adhesive layer 11. Given this point, in the present embodiment, the adhesive layer 11 containing the following characteristics is used.

In the present embodiment, the adhesive layer 11 has an adhesive strength of 0.01 N/25 mm or more to a PET film. In addition, when the wiring pattern 12 is formed on the adhesive layer 11 using inkjet technique, the adhesive strength of the adhesive layer 11 to the PET film may be 0.01 to 50 N/25 mm. In addition, when the wiring pattern 12 is formed on the adhesive layer 11 using screen printing technique, the adhesive strength of the adhesive layer 11 to the PET film may be 0.01 to 0.20 N/25 mm. That is, when the screen-printing technique is used, it is preferable to weaken the adhesive strength of the adhesive layer 11 compared to the case where the inkjet technique is used. Adhesive strength to PET film can be measured by performing a 180° peel test (sample width 25 mm) using a tensile testing machine.

In addition, in the present embodiment, the material in which the layer thickness variation when the adhesive layer is immersed in isopropyl alcohol (IPA) for 1 minute is 20% or less, and the layer thickness variation when the adhesive layer is immersed in toluene for 1 minute is 18% or less is used for the adhesive layer 11. At the time, the layer thickness variation when the adhesive layer is immersed in isopropyl alcohol (IPA) for 1 minute is preferably 20% or less, more preferably 14% or less, and still more preferably 7% or less. In addition, the layer thickness variation when the adhesive layer is immersed in toluene for 1 minute is preferably 18% or less, more preferably 13% or less, and still more preferably 11% or less.

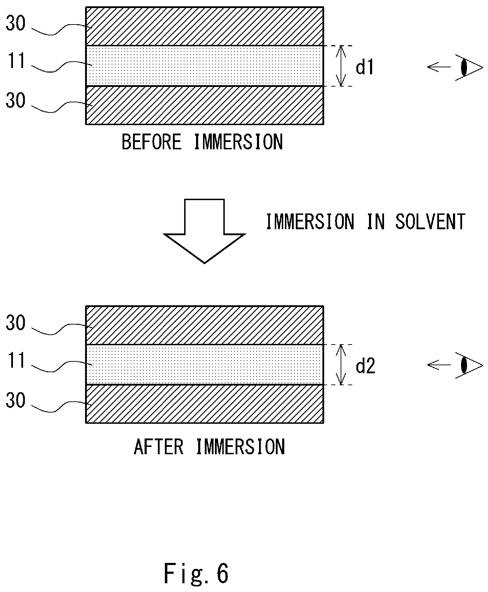

Here, as shown in Fig. 6, "layer thickness variation" is expressed as (d2 - d1)/d1 × 100(%), where d1 is the thickness of the side surface of the adhesive layer 11 before immersion in the solvent and d2 is the thickness of side surface of the adhesive layer 11 after immersion in the solvent for 1 minute. In addition, for measuring the layer thickness variation, a sample with PET substrate 30 adhered to both sides of the adhesive layer 11 may be used. For a sample that is stacked body, the sample may be used in a state of stacked body, and the cut surface of the sample may be cut out by cutting tool such as a razor blade, tungsten blade, or a diamond knife, or may be processed by ion milling or other processing.

For example, if the adhesive layer 11 is susceptible to the solvent, when the sample is immersed in the solvent, the adhesive layer 11 is affected by the solvent and the adhesive layer 11 swells. When the adhesive layer 11 swells in this way, the thickness d2 of the adhesive layer 11 after immersion increases, so that the layer thickness variation increases. Furthermore, when the solvent dries some time after immersion, it returns to a state close to the original adhesive layer thickness d1, so that the layer thickness variation of shrinkage after swelling also increases. That is, when the material having a large layer thickness variation is used as the adhesive layer 11, it is susceptible to the influence of solvent, low molecular component, and the like contained in the conductive ink material. For this reason, since swelling and shrinkage of the adhesive layer directly below the wiring after wiring pattern printing occurs largely, it is directly subjected to this dimensional change, and crack and buckling are likely to occur in the wiring pattern 12. In particular, when the solubility of adhesive layer material in the conductive ink solvent is high, the shape of the adhesive layer is collapsed by the elution of the adhesive layer material to the conductive ink, and it is difficult to form a normal wiring on the adhesive layer. For this reason, wiring may be formed including crack and buckling in the wiring pattern 12.

Therefore, in the present embodiment, the material in which the layer thickness variation when the adhesive layer is immersed in isopropyl alcohol (IPA) for 1 minute is 20% or less, and the layer thickness variation when the adhesive layer is immersed in toluene for 1 minute is 18% or less is used for the adhesive layer 11. If the material containing such characteristics is used for the adhesive layer 11, the solvent contained in the conductive ink material can be suppressed from penetrating into the adhesive layer 11 when the wiring pattern 12 is drawn directly on the adhesive layer 11, thereby suppressing the occurrence of crack and buckling in the wiring pattern 12.

That is, when the wiring pattern 12 is drawn directly on the adhesive layer 11, dimensional changes caused by swelling of the adhesive layer 11 by the solvent contained in the conductive ink material or shrinkage of the adhesive layer 11 when the solvent dries can be suppressed. Therefore, the occurrence of crack and buckling due to such dimensional changes can be suppressed.

In the present embodiment, isopropyl alcohol is used as a representative of the polar solvent and toluene is used as a representative of the non-polar solvent. That is, a material in which the layer thickness variation when immersed in both a polar solvent and a non-polar solvent satisfies the above conditions is used as the adhesive layer 11. The adhesive layer 11 that satisfies the above conditions can be said to be a material with low solvent penetration for a wide range of solvents. Other examples of polar solvents include alcoholic solvents such as methanol, ethanol, 1-propanol, and 1-butanol, ketonic solvents such as methyl ethyl ketone, methyl isobutyl ketone, cyclopentanone, and cyclohexanone, acetate ester solvents such as methyl acetate, ethyl acetate, propyl acetate, and butyl acetate, glycol ether solvents such as propylene glycol monomethyl ether, and propylene glycol monomethyl ether acetate, and other solvents. Other examples of non-polar solvents include hydrocarbon solvents such as xylene, n-hexane, cyclohexane, and benzene.

In the present embodiment, the adhesive layer (OCA) 11 can use a material that satisfies a specific solvent penetration characteristic, such as acryl based, silicone-based, epoxy based, or urethane acrylate based. In addition, the adhesive layer 11 may have a post-curing characteristic such as thermosetting or UV curability. In addition, the adhesive layer 11 may have characteristics such as softening and adhering when heated (hot melt).

In addition, in the present embodiment, the thickness of the adhesive layer 11 may be 5 µm to 200 µm. In addition, when the wiring pattern 12 is formed on the adhesive layer 11 using inkjet technique, the thickness of the adhesive layer 11 may be 10 µm to 200 µm. In addition, when the wiring pattern 12 is formed on the adhesive layer 11 using screen printing technique, the thickness of the adhesive layer 11 may be 5 µm to 20 µm. That is, when the screen-printing technique is used, it is preferable to reduce the thickness of the adhesive layer 11 compared to the case where the inkjet technique is used.

In addition, in the present embodiment, a material in which a solvent is dropped onto the adhesive layer and the contact angle after 1 minute is 30° or less, preferably 20° or less, and more preferably 10° or less may be used as the adhesive layer 11. For the solvent to be dropped, a mixed solvent having a mixing ratio of isopropyl alcohol and toluene of 1:1 can be used. Thus, this small contact angle enables the wiring to be printed with good wettability.

### Examples

Hereinafter, examples will be described.

In the following, a wiring pattern drawing test was performed on the samples according to Example 1 to Example 13. Specifically, in addition to investigating the physical characteristics of each OCA (adhesive layer) according to Example 1 to Example 13, a drawing test was performed using screen printing technique or inkjet printing technique. Table 1 shows the maker, product number, and thickness of the samples (OCA) according to Example 1 to Example 13.

In addition, the adhesive strength of OCA according to Example 1 to Example 13 was measured. Specifically, the 180° peel adhesion strength of OCA when measured at room temperature under conditions of a sample width of 25 mm and a tensile speed of 300 mm/min was measured using an AUTOGRAPH (AG-Xplus) device available from SHIMADZU CORPORATION. Table 1 shows the measured results of the adhesive strength of each OCA.

In addition, the layer thickness variation after solvent immersion was measured using the following method.
First, as shown in Fig. 6, a measurement sample was prepared in which COSMO SHINE A4160 (available from TOYOBO Co., Ltd., 125 µ thick, one-sided easy adhesion) was laminated to the upper surface and lower surface of the OCA (adhesive layer 11) as a PET substrate 30, respectively, so that the non-easy adhesion surface was on the OCA side. Thereafter, the measurement sample was cut, and the cross-section of the measurement sample was cut out (sectioning) using best replacement blades available from KAI CORPORATION. The size of the measurement sample after cut out was 10 mm × 5 mm. Then, the side surface (cross-section) of the measurement sample was observed by high precision imaging with a laser microscope (LEXT OLS4000, available from OLYMPUS), and the thickness d1 of the OCA before immersion was determined by measuring the average value of the distance between parallel lines at three points.

Next, the measurement sample was immersed in isopropyl alcohol (IPA) for 1 minute. Thereafter, the side surface (cross-section) of the measurement sample after immersion was observed by a laser microscope in the same manner as d1, and the thickness d2 of the OCA after immersion was determined. Then, the layer thickness variation for each OCA was determined using the formula: layer thickness variation = (d2 - d1)/d1 × 100 (%). Similarly, the layer thickness variation when OCA was immersed in toluene was also determined. Table 1 shows measured results of the layer thickness variation of each OCA.

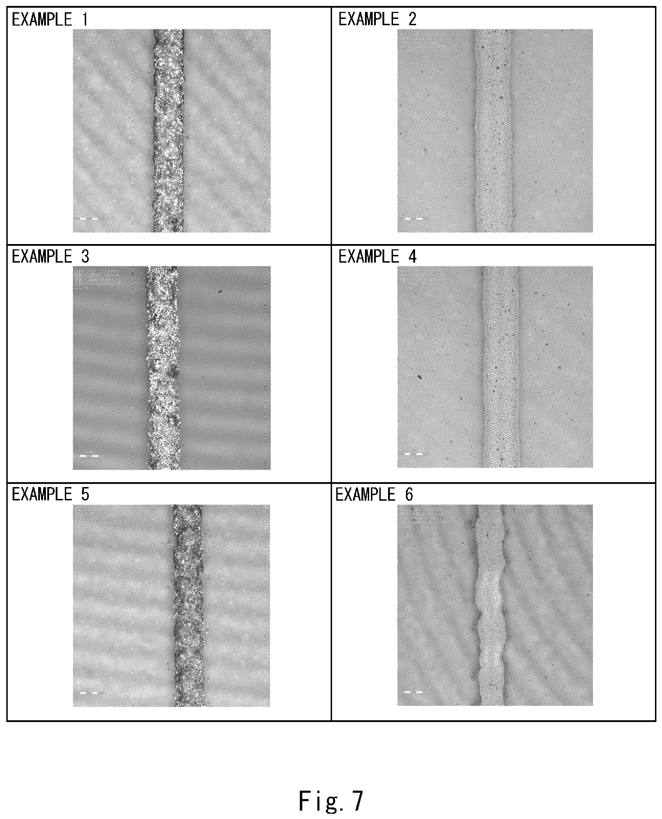

In addition, a drawing test was performed by forming a wiring pattern on the surface of the OCA according to Example 1 to Example 6 using screen printing technique. For the formation of the wiring pattern, a screen plate for wiring printing and a screen-printing squeegee were used. As the conductive ink material, silver paste RA FS 059 S available from TOYO INK CO., LTD. and silver nano ink S-CS21303 available from GenesInk Co., Ltd. were used. The firing conditions after printing were 120°C, 30 min. Table 1 shows the drawing test results of each OCA. Fig. 7 shows the results of the observing the samples by the microscope in which the wiring pattern is printed on the surface of the OCA according to Example 1 to Example 6.

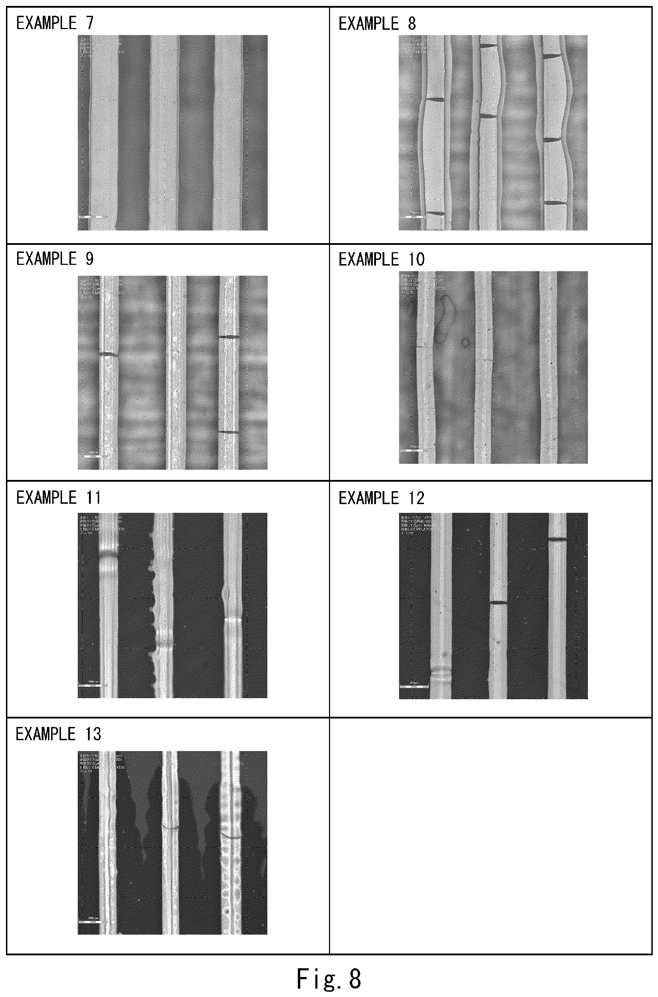

In addition, a drawing test was performed using an inkjet printing technique to form a wiring pattern on the surface of the OCA according to Example 7 to Example 13, which were laminated to a TAC substrate KC4UA (available from KONICA MINOLTA, INC. 40 µm thick). A silver nano ink DNS-0169I available from Daicel Corporation was used as the conductive ink material. The firing conditions after printing were 120°C, 30 min. Table 1 shows the drawing test results of each OCA. Fig. 8 shows the results of the observing the samples by the microscope in which the wiring pattern is printed on the surface of the OCA according to Example 7 to Example 13.

### [Table 1]

**TABLE 1**

| SAMPLE | OCA MAKER | OCA PRODUCT NUMBER | OCA THICKNESS [µm] | ADHESIVE STRENGTH [N/25mm] | LAYER THICKNESS VARIATION AFTER SOLVENT IMMERSION | | PRINTING METHOD | CONDUCTIVE INK | DRAWING TEST RESULT |
|---|---|---|---|---|---|---|---|---|---|
| | | | | | IPA | TOLUENE | | | |
| EXAMPLE 1 | PANAC | ST75 | 8 | 0.10 | 1% | 0% | SCREEN | RA FS 059 S | OK |
| EXAMPLE 2 | PANAC | ST75 | 8 | 0.10 | 1% | 0% | SCREEN | S-CS21303 | OK |
| EXAMPLE 3 | PANAC | NT75 | 8 | 0.17 | 1% | 0% | SCREEN | RA FS 059 S | OK |
| EXAMPLE 4 | PANAC | NT75 | 8 | 0.17 | 1% | 0% | SCREEN | S-CS21303 | OK |
| EXAMPLE 5 | TOKYO FILM SERVICE | TKF-50S | 8 | 0.07 | 0% | 0% | SCREEN | RA FS 059 S | OK |
| EXAMPLE 6 | TOKYO FILM SERVICE | TKF-50S | 8 | 0.07 | or | 0% | SCREEN | S-CS21303 | OK |
| EXAMPLE 7 | GUNZE | CSA-152 | 100 | 13.5 | 6.8%, | 10.2% | INKJET | DNS-0169I | OK |
| EXAMPLE 8 | PANAC | PDSH2 | 25 | 17.1 | 29.1% | ELUTION | INKJET | DNS-0169I | NG |
| EXAMPLE 9 | PANAC | PDR5 | 25 | 16.7 | 1.2% | 19.9% | INKJET | DNS-0169I | NG |
| EXAMPLE 10 | PANAC | PDC3 | 25 | 29.7 | 24.1% | 16.0% | INKJET | DNS-0169I | NG |
| EXAMPLE 11 | PANAC | PDS1S | 25 | 18.4 | 34.1% | 39.1% | INKJET | DNS-0169I | NG |
| EXAMPLE 12 | PANAC | PDS1 | 25 | 18.5 | 39.7% | ELUTION | INKJET | DNS-0169I | NG |
| EXAMPLE 13 | LINTEC | MO-T015C | 25 | 25.0 | ELUTION | ELUTION | INKJET | DNS-0169I | NG |

In Table 1, Example 1 to Example 7 are examples, and Example 8 to Example 13 are comparative examples. As shown in Table 1, in the OCAs according to Example 1 to Example 7, the layer thickness variation after solvent immersion showed low values in both isopropyl alcohol (IPA) and toluene. Thus, it is considered that the drawing test also showed favorable results. As shown in Fig. 7, for example, in the OCA according to Example 7, a wiring pattern without crack and buckling could be formed on the surface of the OCA.

On the other hand, in the OCA according to Example 8, and Example 10 to Example 12, the layer thickness variation when immersed in isopropyl alcohol (IPA) for 1 minute was greater than 20%. In addition, in the OCA according to Example 13, the OCA eluted when immersed in isopropyl alcohol (IPA) for 1 minute. In addition, in the OCA according to Example 9 and Example 11, the layer thickness variation when immersed in toluene for 1 minute was greater than 18%. In addition, in the OCA according to Example 8, Example 12, and Example 13, the OCA eluted when immersed in toluene for 1 minute. Thus, it is considered that the OCA in Example 8 to Example 13 did not show favorable results for the drawing test. As shown in Fig. 7, for example, in the OCA according to Example 9 and Example 11, crack and buckling occurred in the wiring pattern formed on the surface of the OCA.

In addition, a wiring-attached adhesive substrate with the wiring formed on OCA (ST75) of Example 1 was used to fabricate a stacked device including the configuration shown in Fig. 3. A different wiring was used for an electronic device on the film. When a resistance meter terminal was pressed against a wiring section of the wiring-attached adhesive substrate and a conductivity test was performed, the conductivity between the electronic device and the wiring-attached adhesive substrate was confirmed.

A wiring-attached adhesive substrate formed on OCA (ST75) of Example 1 was used to fabricate a stacked device including the configuration shown in Fig. 4. A different wiring was used for an electronic device on the film. As the overcoat layer was coated photolec A784-60 (available from SEKISUI CHEMICAL CO., LTD.), which was laminated with PET substrate A4160 (available from TOYOBO Co., Ltd., 125 µm thick), and adhered through UV curing by irradiation with a light amount of 1000 mj/o. When a resistance meter terminal was pressed against a wiring section of the wiring-attached adhesive substrate and a conductivity test was performed, the conductivity between the electronic device and the wiring-attached adhesive substrate was confirmed.

A wiring-attached adhesive substrate formed on OCA (ST75) of Example 1 was used to fabricate a glass stacked body including the configuration shown in Fig. 5. A different wiring was used for an electronic device on the film. As the overcoat layer was coated photolec A784-60 (available from SEKISUI CHEMICAL CO., LTD.), which was laminated with PET substrate A4160 (available from TOYOBO Co., Ltd., 125 µm thick), and adhered by UV curing. PVB sheets (15 mil thick) were adhered to both sides of the laminated film and encapsulated in laminated glass. When a resistance meter terminal was pressed against a wiring section of the wiring-attached adhesive substrate and a conductivity test was performed, the conductivity between the electronic device and the wiring-attached adhesive substrate was confirmed.

Although the present invention has been described with reference to the above-described embodiments, the present invention is not limited to the configuration of the above-described embodiments, but of course includes various modifications, alterations, and combinations that can be made by a person skilled in the art within the scope of the claimed invention in the claims of this application.

This application claims priority based on Japanese Application Patent Application No. 2022-128817, filed August 12, 2022, the disclosure of which is hereby incorporated in its entirety.

### Reference Signs List

1 WIRING-ATTACHED ADHESIVE SUBSTRATE
2,3 STACKED DEVICE
4 GLASS STACKED BODY
10 SUBSTRATE
11 ADHESIVE LAYER
12 WIRING PATTERN (WIRING)
15 ELECTRONIC DEVICE
16 OVER COAT LAYER
17 SUBSTRATE
21a, 21b INTERMEDIATE BONDING LAYER
22a, 22b GLASS PLATE

## Claims

1. A wiring-attached adhesive substrate, comprising:
a substrate;
an adhesive layer formed on the substrate; and
wiring pattern formed on the adhesive layer, wherein
the adhesive layer has an adhesive strength of 0.01 N/25 mm or more to a PET film, a layer thickness variation of 20% or less when the adhesive layer is immersed in isopropyl alcohol for 1 minute, and a layer thickness variation of 18% or less when the adhesive layer is immersed in toluene for 1 minute.

2. The wiring-attached adhesive substrate according to claim 1, wherein the wiring pattern is formed of a material comprising at least one selected from the group consisting of silver, copper, carbon, and gold.

3. The wiring-attached adhesive substrate according to claim 1 or 2, wherein the light transmittance of the entire surface of the wiring-attached adhesive substrate is 50% or more.

4. A stacked device comprising:
the wiring-attached adhesive substrate according to claim 1 or 2; and
an electronic device disposed on the wiring-attached adhesive substrate, wherein
the electronic device is electrically connected to the wiring pattern formed on the adhesive layer.

5. The stacked device according to claim 4, further comprising an over coat layer covering the electronic device and the wiring pattern.

6. A glass stacked body in which the stacked device according to claim 4 is encapsulated in a glass plate or laminated to the surface of a glass plate.

7. A method for manufacturing a wiring-attached adhesive substrate, comprising:
a step of forming an adhesive layer on a substrate,
a step of forming a wiring pattern on the adhesive layer using a conductive ink material, wherein
the adhesive layer uses a material having an adhesive strength of 0.01 N/25 mm or more to a PET film, a layer thickness variation when the adhesive layer is immersed in isopropyl alcohol for 1 minute is 20% or less, and a layer thickness variation when the adhesive layer is immersed in toluene for 1 minute is 18% or less.

8. The method for manufacturing a wiring-attached adhesive substrate according to claim 7, wherein the step of forming a wiring pattern comprises printing the conductive ink material on the adhesive layer using inkjet technique to form the wiring pattern.

9. The method for manufacturing a wiring-attached adhesive substrate according to claim 8, wherein the step of forming a wiring pattern comprises printing the conductive ink material on the adhesive layer using screen printing technique to form the wiring pattern.
